# EUROPEAN PATENT SPECIFICATION

(11) **EP 0 132 652 B1**
(45) Date of publication and mention of the grant of the patent: **05.05.1993**
(21) Application number: 84107882.7
(22) Date of filing: 05.07.1984
(51) Int. Cl.: B23B 51/02, B23P 15/32

(54) **Method of manufacturing a printed circuit board drill**
Verfahren zur Herstellung eines Bohrers für Leiterplatten
Procédé pour la fabrication d'un fôret pour plaquettes de circuits imprimés

(30) Priority: 21.07.1983 US 515777
(43) Date of publication of application: 13.02.1985
(73) Proprietor: Precorp Inc., Niles, IL 60648 (US)
(72) Inventor: Bunting, John Alan, Provo Utah 84604 (US); Clark, James Larsen, Provo Utah 84604 (US); Pope, Louis McConkie, Provo Utah 84604 (US)
(74) Representative: Grünecker, Kinkeldey, Stockmair & Schwanhäusser Anwaltssozietät

(56) References cited:
- EP-A- 0 054 250
- EP-A- 0 079 243
- DE-A- 3 232 686
- DE-C- 345 911
- DE-C- 493 860
- DE-C- 594 043
- US-A- 1 887 372
- US-A- 3 743 489
- US-A- 3 745 623
- US-A- 4 186 628
- US-A- 4 228 942
- US-A- 4 334 928

## Description

The present invention relates to a method of manufacturing a rotary cutting tool drill for a printed circuit board.

In the manufacture of circuit boards, patterns of electically conductive foil are imprinted on boards made of fiberglass-reinforced plastic. Since the patterns are formed on both surfaces of a double-layer board, plus in the interior of multi-layer boards, electrical connection between conductors of adjacent patterns is accomplished through metal plating. Small holes are drilled in the board through the conductors and a conductive metal then deposited from one conductor through the hole to the other conductor or conductors. To ensure proper electrical contact with all of the conductors, the metal must flow through the plate or coat the entire surface of the hole. Therefore, each hole must be regular in size, have a smooth surface, and be free from burrs and resin smear. This requires a very sharp drill and precise drilling techniques.

The printed circuit boards are usually made of copper-clad glass-epoxy laminates which are extremely abrasive. Therefore, a drill which is suitable for use with such materials should be as wear-resistant as possible in order to maintain a cutting edge. For efficiency in manufacture, similar boards are commonly stacked and drilled simultaneously. The drills must, therefore, be of sufficient length to pass through three or more boards, and for acceptable top to bottom registration, they must be rigid. Because of the small size of the holes i.e, 0,15 to 3,2 mm (.006 to .125 inches), the drills are very slender and elongated. This fact, coupled with the axial thrust loading applied to the drills, dictates that the drill material should be as tough as possible. These properties, i.e., rigidity, toughness and resistance to wear are mutually exclusive, since the most wear-resistant materials tend also to be brittle, while the toughest materials tend also to wear rapidly. These differing requirements have therefore necessitated compromises in the choice of the materials heretofore used in the manufacture of such drills. While drills have been made of various materials, the composition of material used in the body of each drill has been uniform over its entire length. As a result, the cutting surfaces have been somewhat less wear resistant and the remainder of the body somewhat more brittle than would otherwise be desireable. Tool designers have thus found great challenge in selecting tool materials with the best compromises between wear resistance and toughness. Beyond a certain point, marginal improvement in wear-resistance has substantially increased the risk of an unacceptable rate of tool failure from breakage; conversely, an unbreakable tool has proven to wear very rapidly.

In the drilling process, rapid removal of the chips is necessary to prevent overheating of the drill, which causes dulling of the cutting edges and also melting of the board material, which in turn produces resin smear in the hole. Therefore, a twist drill having helical flutes is commonly used between 750 and 1500 times in drilling multi-layer boards and then resharpened to restore the cutting surfaces. Because of the back taper given to the drills, they can usually be resharpened only three to five times before the diameter and correspondingly, the diameter of the hole, is reduced and becomes unacceptable. Heretofore, the most wear resistant materials known, i.e., diamond and cubic boron nitride, have not been available for use in drills of the size employed with printed circuit boards. The difficulties involved in handling crystalline compacts of diamond or cubic boron nitride of the very small dimensions required for abrasive tipped printed circuit board (PCB) drills, and then the further difficulties of grinding such compacts to produce the webs, lips, and edges, have precluded the use of these materials in drills of the size required.

From EP-A-00 79 243, there is known a composite tip for use in a drill including a generally cylindrical blank having abrasive particles to its free end, wherein said blank consists of cemented carbide and said abrasive particles are bonded to each other and to the cemented material of the blank by sintering.

Furthermore, there is known from US-A-3,745,623, a diamond tipped machine tool in which, in place of utilising a single diamond, the working diamond content is present in the form of a mass of diamond crystals bonded to each other or in the form of a thin skin of diamond crystals bonded to each other. In both of the above-indicated prior art, the abrasive particulate is merely attached after the rotary cutting tool has already been formed. In particular, a separately compacted piece of abrasive is attached to the desired area of an already fully machined drill with its carbide carrier layer positioned between the diamond abrasive material and the carbide of the drill. A second carrier layer of nickel is commonly used during the brazing process to attach the opposite side face of the diamond abrasive material insert to the carbide material of the pre-formed drill.

Furthermore US-A-1 887 372, figures 1 and 2, discloses a composite sintered abrasive rotary cutting tool blank capable of being formed into a rotary cutting tool, said rotary cutting tool blank comprising: a drill blank including a conically shaped point region of said first material at said top end of said cylindrically shaped region; one or more veins of sintered abrasive particulate (on page 2, lines 85-90 it is disclosed that the working parts can be of sintered carbide) extending longitudinally from said conically shaped point region at said top end into said cylindrically shaped region of said drill blank, from the circumferential edge of said drill blank inwardly along at least a portion of the diameter of said drill blank, said sintered abrasive particulate being exposed at only the top conical surface of said conically shaped point region and at the circumferential edges of said cylindrically shaped region, of said drill blank.

In the present invention a method of manufacturing a rotary cutting tool drill for a printed circuit board is provided which facilitates the use of the most wear resistant materials, such as diamond or cubic boron nitride, as the cutting surfaces and materials having the highest transverse rupture strength and toughness, such as high tensile strength carbides or low carbon steels, as the shank and body of the drill.

This is accomplished by the method steps as recited in claim 1.

In particular there is formed a composite sintered abrasive tip of cemented carbide and of diamond or cubic boron nitride, such that the cemented carbide can be ground away to expose the abrasive as the cutting surfaces, without grinding significant amounts of the abrasive. A cemented carbide or steel shank with a reduced section is provided to form the shank and body of the drill. The tip is attached to the free end of the reduced section and helical flutes are ground over the combined length of the tip and the reduced section.

The best mode presently contemplated of carrying out the invention will be understood from the detailed description of the preferred embodiments illustrated in the accompanying drawing in which:
Fig. 1a is a perspective view, and 1b is an end view, of a cemented carbide blank according to the present invention;
Fig. 2 is a perspective view of a sintered composite abrasive tip;
Fig. 3 is an elevation view of a shank and body with the tip of Fig. 2 attached;
Fig. 4 is an elevation view of a helical fluted PCB drill according to the present invention;
Fig. 5 is an end view of a helically fluted twist drill with the various parts identified;
Fig. 6 is an end view of the drill of Fig. 4;
Fig. 7a is an elevation view in section and 7b an end view of another embodiment; and
Fig. 8a is an elevation view in section, 8b is an end view, and 8c is an elevation view of another embodiment.

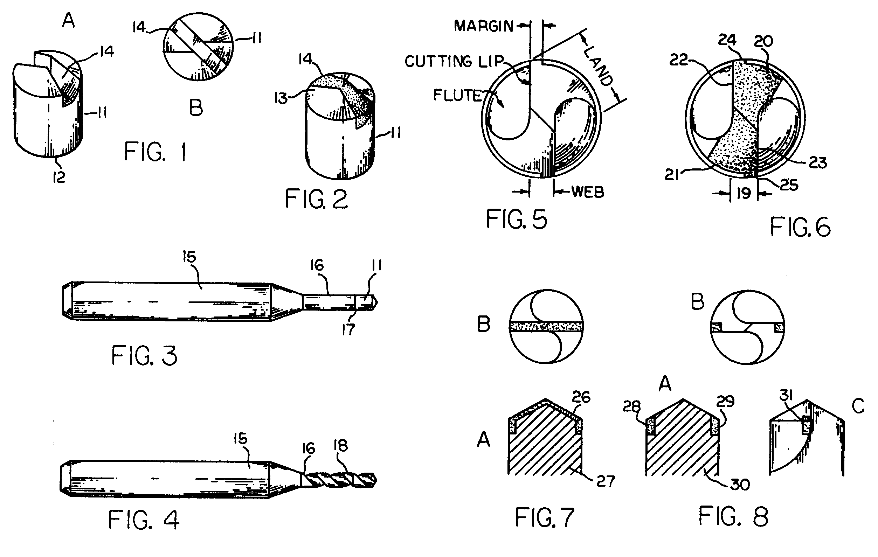

The present invention contemplates provision of an improved helically-fluted PCB drill in the range of 0,15 to 3,2 mm (.006 to .125 inch) diameters in which the body is formed of material having high transverse rupture strength and optimum toughness, while the cutting surfaces are composite sintered abrasive having optimum wear resistance. This drill has extended effective life and is capable of producing several times the number of quality holes in multi-layer boards achieved by the best standard tungsten carbide drills. The present drill involves a composite sintered abrasive tip in which the abrasive is arranged in a predetermined shape and location at one end. As shown in Fig. 1 of the drawing, a preferred embodiment includes a generally cylindrical blank 11 made of a suitable cemented carbide, such a tungsten carbide. In the selection of material of the blank, the wear resistance properties do not predominate. Instead, consideration is given to other properties, such as transverse rupture strength, toughness, ease of brazing or welding, and ease of grinding. The blank is so dimensioend as to be easy to handle, the length being approximately two or three times the diameter. One end 12 of the blank is flat to provide an attachment surface, while the opposite end 13 is conical and is provided with a transverse groove 14. The groove is located on a diameter of the blank and extends across the full width of the blank. The configuration of the groove is ideally that of a rectangle which is revolved about the longitudinal axis of the blank as it extends along said axis into the blank. The angle of revolution corresponds to the helix angle selected for the drill and is normally approximately 25° to 45°. In practice, as shown in Fig. 1, the groove may resemble a rectangular prism with a wedge-shaped arcuate segment protruding from each side adjacent the opposite ends, the segments tapering oppositely toward the adjacent end of the prism at the bottom of the groove. The width of the groove may vary from approximately 1/8 to 1/3 the diameter of the blank 11 depending on the design of the drill, since the groove width corresponds to the thickness of the web desired for the drill. The groove 14 may be formed in the blank 11 by a suitable die when the blank 11 is formed, or it may be machined into the blank 11 after the blank 11 is formed.

A mass of abrasive particles, i.e., diamond or cubic boron nitride, of from 1 to 200 µm, preferably between 4-8 µm, is mixed with a suitable fugitive binder. such as parafin, etc., and packed into the groove 14, so as to completely fill the groove, including the conical end. The blank 11 with the abrasive is then placed in a tubular mold made of molybdenum or other refractory metals, along with a disc of suitable catalytic sintering aid such as cobalt, iron, nickel, etc. Alternatively, the diamond is mixed with metals, metal compounds or metal alloy powders of a suitable catalytic sintering aid. A cap of this catalytic sintering aid or refractory metal with an internal cone-shaped surface is placed on the mold over the abrasive and the mold is then loaded into a high pressure, high temperature (HP/HT) press. The contents of the mold are then subjected to pressures of 45.10⁵kPa (45Kbar) to 75.10⁵kPa (75Kbar) and temperatures of 1200°C to 1600°C for approximately 1 to 20 minutes. Apparatus and techniques for such sintering are disclosed in U.S. patents 2,941,248; 3,141,746; 3,745,623; and 3,743,489 (incorporated herein by reference). When the abrasive mass is fully sintered, with the particles bonded to each other and to the carbide, the blank is removed from the press. As shown in Figure 2, the resultant composite sintered abrasive tip is made up of a cemented carbide cylinder with a vein 10 of fully sintered abrasive particles imbedded in and extending across one end thereof.

The composite sintered abrasive tip is attached to a shank 15 made of a suitable tough material, such as steel, tungsten carbide, etc., which has high transverse rupture strength and rigidity. The shank 15, Fig. 3, is formed or machined with a reduced section 16 which makes up the body of the drill. The flat end 12 of the tip is brazed or similarly secured to the similarly flat end 17 of the reduced section. As shown in Fig. 4, helical flutes 18 are then machined or ground in the tip and the reduced section. The flutes begin at the conical end in the cemented carbide on either side of the abrasive vein and then proceed around the tip at the helix angle. The abrasive vein forms the web 19 and the lands 20, 21 of the drill as illustrated in Fig. 5 and 6. The taper of the vein exposes protruding edges 22 and 23 which form the cutting lips of the drill. As the carbide is removed during the fluting operation, portions of the abrasive vein are exposed and define sections of the flutes. The web behind the edges 22 and 23 is provided with a desired angle or rake, either by shaping the cap of the mold in which the tip is sintered or by subsequent grinding. Depending on the design of the drill ribs 24 and 25 may be formed during the sintering process and then exposed when the carbide is subsequently removed from the remainder of the lands 20 and 21 by grinding. The abrasive vein is extremely hard and very difficult and time consuming to grind. Accordingly, it is desireable to mold the abrasive mass and then sinter it, as close as possible, to the finished configuration desired for the drill.

Alternative embodiments of tip constructions are illustrated in Figs. 7 and 8. In the embodiment of Figs. 7a and 7b the abrasive vein 26 is imbedded in a shallow groove which extends across the end of the tip 27 and a short distance down the opposite sides. In the embodiment of Figs. 8a, 8b, and 8c the abrasive vein may be discontinuous, being in segments 28 and 29 which are imbedded in groove sections formed in the end of the tip 30 at the opposite extremeties of a diameter thereof. The sections of the groove are formed at the corners of the tip and are deep enough that the abrasive vein is exposed along the sides of the tip as well as across at least portions of the end. The edge 31 of both sections of the groove is preferably tapered in the direction of the flute and at the helix angle, so that the leading edges of the abrasive vein segments imbedded therein will accommodate the flutes when they are ground. In the embodiments of Figs. 7 and 8 the abrasive vein is located at the extremity of the tip and exposed at the end and along opposite sides thereof. When the flutes are ground and the tip pointed, the abrasive vein forms the cutting surfaces of the drill. In this respect, the great majority of the cutting action, and resultant wear, of the drill occurs at the corners where the abrasive is located. In the embodiment of Fig. 8, while the sections of the groove are illustrated as separated by a section of carbide it may be desireable, in some instances, to extend the sections such that the groove, and thereby the vein of the abrasive, is continuous across the end of the tip. It is understood that in the embodiments of Figs. 7 and 8, similarly to Figs. 1 and 2, the abrasive mixture is packed in the groove; the blank and abrasive is placed in a mold and then sintered in a HP/HT press. The tip is then attached to the reduced section of a shank and the body of the drill fluted. The end of the tip is then pointed and finished to provide the finished drill.

Applicants have provided an improved construction and method of manufacture for PCB drills in the range of 0,15 to 3,2 mm (.006 to .125 inches) in diameter which facilitates the use of materials having the optimum wear resistance, transverse rupture strength and toughness properties. While the present teachings are primarily applicable to PCB drills in the specified range, it is contemplated that the same construction and method of manufacture may, in some instances, be applicable to drills outside the range.

While the invention has been described with reference to specifically illustrated preferred embodiments, it should be realized that various changes may be made without departing from the disclosed inventive subject matter claimed herebelow.

## Claims

1. Method of manufacturing a rotary cutting tool drill for a printed circuit board comprising
(A) forming a drill blank (11) having a cylindrically shaped region of a first material of cemented carbide of suitable toughness,
(B) providing a conically shaped point region (13) of said first material at a top side of said cylindrically shaped region,
(C) forming one or more veins (14) in said drill blank (11) to extend longitudinally from the top of said conically shaped point region (13) into said cylindrically shaped region, said one or more veins (14) extending from the circumferential edge of said drill blank (11) inwardly along at least a portion of the diameter of said drill blank (11),
(D) filling said one or more veins (14) completely by a mass of abrasive particulate,
(E) Sintering and bonding said regions of first material of said drill blank (11) to the one or more veins (14) filled with said mass of abrasive particulate without the utilization of intermediary carrier and substrate material,
(F) exposing said one or more veins (14) at the top conical surface of said conically shaped point region (13) and at the circumferential edges of said cylindrically shaped region of said drill blank (11),
(G) attaching said drill blank to a shank member (15), and
(H) forming said drill blank (11) into said rotary cutting tool (19-25) through the processes of fluting, grinding and finishing of said drill blank (11),
- said one or more veins (14) retaining their position within said drill blank upon formation of said drill blank (11) into said rotary cutting tool (19-25) at which time the longitudinal edges (22, 23) of said one or more veins (14) of sintered abrasive particulate are exposed to form the cutting surface elements of said rotary cutting tool (19-25).

2. The method according to Claim 1 in which said one or more veins (14) of sintered abrasive particulate are exposed at the circumferential edges of said cylindrically shaped region of said drill blank (11) at diametrically opposed positions along said drill blank (11).

3. The method according to Claim 1 in which said one or more veins (14) of sintered abrasive particulate comprises a single vein extending across the diameter of said drill blank (11),
- said single vein having the geometric configuration of a rectangular prism with parallel opposite sides, and extending longitudinally from said top of said conically shaped point region (13) into said cylindrically shaped region of said drill blank (11).

4. The method according to Claim 1 in which said one or more veins (14) of sintered abrasive particulate comprises a single vein extending across the diameter of said drill blank (11),
- said single vein (14) having the geometric configuration of a rectangular prism with a radially disposed hour-glass shape, and extending longitudinally from said top of said conically shaped point region (13) into said cylindrically shaped region of said drill blank (11).

5. The method according to Claim 1 in which said one or more veins (14) of sintered abrasive particulate extend longitudinally from the top of said conically shaped point region (13) into said cylindrically shaped region of said drill blank (11) at an acute angle relative to the longitudinal axis of said drill blank (11).

6. The method according to Claim 1 in which said first material comprises a carbide material; said sintered abrasive particulate comprising a diamond material.

7. The method according to Claim 1 in which said first material comprises a carbide material; said sintered abrasive particulate comprising a cubic boron nitride material.

8. The method according to Claim 1 in which said one or more veins (14) of sintered abrasive particulate comprises a single vein extending longitudinally from the top of said conically shaped point region (13) into said cylindrically shaped region of said drill blank (11) a first distance,
- said single vein (26) including end regions along diametrically opposite circumferential edges of said drill blank (11), which end regions extend longitudinally into said cylindrically shaped region a second distance greater than said first distance.

9. The method according to Claim 1 in which said one or more veins (14) of sintered abrasive particulate extending longitudinally from the top of said conically shaped point region (13) into said cylindrically shaped region of said drill blank (11) comprises two diametrically opposed separated veins (28, 29) extending radially inwardly from their respective circumferential edges of said drill blank (11).

10. The method according to Claim 1 in which said shank member (15) includes a reduced section (16) extending from one end thereof for fixed and restrained attachment to the bottom side (12) of said cylindrically shaped region of said drill blank (11).

## Patentansprüche

1. Verfahren zur Herstellung eines rotierenden Schneidbohrers für eine bedruckte Leiterplatte, umfassend
(A) Bilden eines Bohrerrohstückes (11) mit einem zylindrisch geformten Bereich aus einem ersten Material aus Sintercarbid von geeigneter Zähigkeit,
(B) Bereitstellen eines konisch geformten Punktbereiches (13) aus diesem ersten Material an einer oberen Seite dieses zylindrisch geformten Bereiches,
(C) Bilden eines oder mehrerer Gänge (14) in diesem Bohrerrohstück (11), welche sich der Länge nach von der Spitze dieses konisch geformten Punktbereiches (13) in diesen zylindrisch geformten Bereich erstrecken, wobei sich der eine oder die mehreren Gänge (14), ausgehend von der umlaufenden Kante dieses Bohrerrohstückes (11), nach innen entlang wenigstens eines Bereiches des Durchmessers dieses Bohrerrohstückes (11) erstrecken,
(D) vollständiges Anfüllen des oder der Gänge (14) mit einer Masse, bestehend aus schleifenden Teilchen,
(E) Sintern und Verbinden dieser Bereiche aus diesem ersten Material dieses Bohrerrohstückes (11) mit dem oder den Gängen (14), welche mit dieser Masse aus schleifenden Teilchen aufgefüllt sind, ohne daß ein dazwischenliegender Träger und Substratmaterial verwendet wird,
(F) Freilegen des einen oder der mehreren Gängen (14) an der oberen, konischen Fläche dieses konisch geformten Punktbereiches (13) und an den umlaufenden Kanten dieses zylindrisch geformten Bereiches dieses Bohrerrohstückes (11),
(G) Anbringen dieses Bohrerrohstückes an ein Schaftelement (15) und
(H) Formen dieses Bohrerrohstückes (11) zu diesem rotierenden Schneidwerkzeug (19 - 25) durch das Verfahren des Auskehlens, Schleifens und Fertigstellens dieses Bohrerrohstückes (11)
- wobei dieser eine oder diese mehreren Gänge (14) an ihrer Position innerhalb dieses Bohrerrohstückes bei der Ausbildung dieses Bohrerrohstückes (11) in dieses rotierende Schneidwerkzeug (19 - 25) verbleiben, wobei zu dieser Zeit die länglichen Kanten (22, 23) dieses einen oder dieser mehreren Gänge (14) aus gesinterten, schleifenden Teilchen freigelegt werden, um die Schneidoberflächenelemente dieses rotierenden Schneidwerkzeuges (19 - 25) zu bilden.

2. Verfahren nach Anspruch 1, wobei dieser eine oder diese mehreren Gänge (14) aus gesinterten, schleifenden Teilchen an den umlaufenden Kanten dieses zylindrisch geformten Bereiches dieses Bohrerrohstückes (11) an aneinander gegenüberliegenden Bereichen entlang dieses Bohrerrohstückes (11) freigelegt werden.

3. Verfahren nach Anspruch 1, wobei dieser eine oder diese mehreren Gänge (14) aus gesinterten, schleifenden Teilchen einen einzelnen Gang umfassen, welcher sich über den Durchmesser dieses Bohrerrohstückes (11) erstreckt,
- wobei dieser einzelne Gang eine Geometrieanordnung aus einem rechteckigen Prisma mit parallelen gegenüberliegenden Seiten aufweist und sich der Länge nach von der Spitze dieses konisch geformten Punktbereiches (13) zu diesem zylindrisch geformten Bereich dieses Bohrerrohrstückes (11) erstreckt.

4. Verfahren nach Anspruch 1, wobei der eine oder die mehreren Gänge (14) aus gesinterten, schleifenden Teilchen einen einzelnen Gang umfassen, welcher sich über den Durchmessers dieses Bohrerrohstückes (11) erstreckt,
- wobei dieser einzelne Gang (14) eine Geometrieanordnung aus einem rechteckigen Prisma mit einer radial angeordneten Uhrglasform ausweist und sich der Länge nach von der Spitze dieses konisch geformten Punktbereiches (13) zu diesem zylindrisch geformten Bereich dieses Bohrerrohstückes (11) erstreckt.

5. Verfahren nach Anspruch 1, wobei sich dieser eine oder diese mehreren Gänge (14) aus gesinterten, schleifenden Teilchen sich der Länge nach von der Spitze dieses konisch geformten Punktbereiches (13) zu diesem zylindrisch geformten Bereich dieses Bohrerrohstückes (13) unter einem spitzen Winkel relativ zu der Längsachse dieses Bohrerrohstückes (11) erstrecken.

6. Verfahren nach Anspruch 1, wobei dieses erste Material ein Carbidmaterial und diese gesinterten, schleifenden Teilchen ein Diamantmaterial umfassen.

7. Verfahren nach Anspruch 1, wobei dieses erste Material ein Carbidmaterial und diese gesinterten, schleifenden Teilchen ein kubisches Bornitridmaterial umfassen.

8. Verfahren nach Anspruch 1, wobei der eine oder die mehreren Gänge (14) aus gesinterten, schleifenden Teilchen einen einzelnen Gang umfassen, welcher sich der Länge nach von der Spitze dieses konisch geformten Punktbereiches (13) zu diesem zylindrisch geformten Bereich dieses Bohrerrohstückes (11) über eine erste Entfernung erstreckt;
- wobei dieser einzelne Gang (26) entlang der einander gegenüberliegenden umlaufenden Kanten dieses Bohrerrohrstückes (11) Endbereiche umfaßt und wobei die Endbereiche sich der Länge nach in diesen zylindrisch geformten Bereich über eine zweite Entfernung erstrecken, welche größer ist als diese erste Entfernung.

9. Verfahren nach Anspruch 1, wobei der oder die Gänge (14) aus gesinterten, schleifenden Teilchen, welche sich der Länge nach von der Spitze dieses konisch geformten Punktbereiches (13) zu diesem zylindrisch geformten Bereich dieses Bohrerrohstückes (11) erstrecken, zwei einander gegenüberliegende, voneinander getrennte Gänge (28, 29) umfassen, welche sich radial nach innen von den jeweiligen umlaufenden Kanten dieses Bohrerrohstückes (11) erstrecken.

10. Verfahren nach Anspruch 1, wobei dieses Schaftelement (15) einen verringerten Bereich (16) umfaßt, welcher sich an einem Ende des Schaftelementes erstreckt zur haltenden und befestigenden Anordnung an der unteren Seite (12) dieses zylindrisch geformten Bereiches dieses Bohrerrohstückes (11).

## Revendications

1. Procédé de fabrication d'un foret de coupe rotatif pour une plaquette de circuit imprimé, consistant à
(A) former une ébauche de foret (11) présentant une région, de forme cylindrique, d'un premier matériau à base de carbure cémenté de ténacité convenable,
(B) prévoir une région (13) en pointe de forme conique dudit premier matériau à la face supérieure de ladite région de forme cylindrique,
(C) former une ou plusieurs fourrures (14) dans ladite ébauche de foret (11) de façon qu'elle s'étendent longitudinalement, depuis l'extrémité supérieure de ladite région (13) en pointe de forme conique, dans ladite région de forme cylindrique, ladite fourrure, ou lesdites plusieurs fourrures (14), s'étendant, depuis le bord circonférentiel de ladite ébauche de foret (11), vers l'intérieur le long d'au moins une portion du diamètre de ladite ébauche de foret (11),
(D) remplir complètement d'une masse de particules abrasives ladite fourrure, ou lesdites plusieurs fourrures (14),
(E) fritter et lier lesdites régions de premier matériau de ladite ébauche de foret (11) à la fourrure, ou aux plusieurs fourrures (14), remplies de ladite masse de particules abrasives, sans utilisation de matériau support et substrat intermédiaire,
(F) faire apparaitre ladite fourrure, ou lesdites plusieurs fourrures (14), à la surface conique supérieure de ladite région en pointe de forme conique (13) et aux bords circonférentiels de ladite région de forme cylindrique de ladite ébauche de foret (11),
(G) fixer ladite ébauche de foret à un élément formant queue (15), et
(H) former ladite ébauche de foret (11) en un dit outil de coupe rotatif (19-25) par les processus de goujurage, meulage et finition de ladite ébauche de foret (11),
- ladite fourrure, ou lesdites plusieurs fourrures (14) conservant leur position dans ladite ébauche de foret lors de la formation de ladite ébauche de foret (11) en un dit outil de coupe rotative (19-25), moment auquel les bords longitudinaux (22, 23) de ladite fourrure, ou desdites plusieurs fourrures (14), de particule abrasives frittées apparaissent vues pour former les éléments de surface de coupe dudit outil de coupe rotatif (19-25).

2. Procédé selon la revendication 1, dans lequel ladite fourrure, ou lesdites plusieurs fourrures (14), de particules abrasives frittées, apparaissent vues aux bords circonférentiels de ladite région, de forme cylindrique, de ladite ébauche de foret (11), en des positions diamétralement opposées le long de ladite ébauche de foret (11).

3. Procédé selon la revendication 1 dans lequel ladite fourrure, ou lesdites plusieurs fourrures (14), de particules abrasives frittées sont constituées d'une unique fourrure s'étendant de part et d'autre du diamètre de ladite ébauche de foret (11),
- ladite fourrure unique ayant la configuration géométrique d'un prisme rectangulaire à faces opposées parallèles, et s'étendant longitudinalement, depuis ladite partie supérieure de ladite région en pointe (13) de forme conique, dans ladite région, de forme cylindrique, de ladite ébauche de foret (11).

4. Procédé selon la revendication 1, dans lequel ladite fourrure, ou lesdites plusieurs fourrures (14), de particules abrasives frittées sont constituées d'une unique fourrure s'étendant de part et d'autre du diamètre de ladite ébauche de foret (11),
- ladite fourrure unique (14) ayant la configuration géométrique d'un prisme rectangulaire en forme de sablier disposé radialement, et s'étendant longitudinalement, depuis ladite partie supérieure de ladite région en pointe (13) de forme conique, dans ladite région, de forme cylindrique, de ladite ébauche de foret (11).

5. Procédé selon la revendication 1, dans lequel ladite fourrure, ou lesdits plusieurs fourrures (14), de particules abrasives frittées s'étendent longitudinalement, depuis la partie supérieure de ladite région en pointe (13) de forme conique, dans ladite région de forme cylindrique de ladite ébauche de foret (11), sous un angle aigu par rapport à l'axe longitudinal de ladite ébauche de foret (11).

6. Procédé selon la revendication 1, dans lequel ledit premier matériau est constitué d'un matériau qui est du carbure; lesdites particules abrasives frittées étant constituées d'un matériau qui est du diamant.

7. Procédé selon la revendication 1, dans lequel ledit premier matériau est constitué d'un matériau qui est du carbure; lesdites particules abrasives frittées étant constituées d'un matériau qui est du nitrure de bore cubique.

8. Procédé selon la revendication 1, dans lequel ladite fourrure, ou lesdites plusieurs fourrures (14), de particules abrasives frittées sont constituées d'une unique fourrure s'étendant longitudinalement, sur une première distance, depuis la partie supérieure de ladite région de pointe (13) en forme de cône, dans ladite région de forme cylindrique de ladite ébauche de foret (11),
ladite fourrure unique (26) incluant des régions d'extrémité le long des bords circonférentiels diamétralement opposés de ladite ébauche de foret (11), régions d'extrémité qui s'étendent longitudinalement dans ladite région de forme cylindrique sur une seconde distance supérieure à ladite première distance.

9. Procédé selon la revendication 1, dans lequel ladite fourrure, ou lesdites plusieurs fourrures (14) de particules abrasives frittées s'étendant longitudinalement, depuis la partie supérieure de ladite région de pointe (13) en forme de cône dans ladite région de forme cylindrique de ladite ébauche de foret (14), sont constituées de deux fourrures distinctes (28, 29), diamétralement opposées et s'étendant radialement vers l'intérieur depuis leurs bords circonférentiels respectifs de ladite ébauche de foret (11).

10. Procédé selon la revendication 1, dans lequel ledit élément formant la queue (15) présente une section réduite (16) qui s'étend depuis l'une de ses extrémités pour permettre une fixation fixe et contrainte à la face inférieure (12) de ladite région de forme cylindrique de ladite ébauche de foret (11).
